**Europäisches Patentamt**

**European Patent Office**

**Office européen des brevets**

(19)

(11) Numéro de publication: **0 031 270**
**B1**

(12) # FASCICULE DE BREVET EUROPEEN

(45) Date de publication du fascicule du brevet:
**07.03.84**

(51) Int. Cl.³: **H 03 H 15/00, H 04 N 9/535**

(21) Numéro de dépôt: **80401746.5**

(22) Date de dépôt: **05.12.80**

(54) **Dispositif de filtrage à faible distorsion de phase et circuit de traitement de signaux de télévision couleur comportant un tel dispositif.**

(30) Priorité: **21.12.79 FR 7931484**

(43) Date de publication de la demande:
**01.07.81 Bulletin 81/26**

(45) Mention de la délivrance du brevet:
**07.03.84 Bulletin 84/10**

(84) Etats contractants désignés:
**AT BE CH DE GB IT LI LU NL SE**

(56) Documents cités:
**US - A - 3 999 142**
**US - A - 4 003 008**
**US - A - 4 120 035**

**IEEE JOURNAL OF SOLID-STATE CIRCUITS, vol. SC-7,
no. 4, août 1972 New York US D. FRIED: "Analog
sample-data filter", pages 302-304
INTERNATIONAL JOURNAL OF ELECTRONICS, vol. 45,
no. 2, août 1978 Londres GB A. YESUFU:
"Charge-coupled devices for wideband quadrature
networks" pages 123-128**

(73) Titulaire: **THOMSON-CSF, 173, Boulevard Haussmann,
F-75379 Paris Cedex 08 (FR)**

(72) Inventeur: **Pham van Cang, Luc, THOMSON-CSF -
SCPI 173, bld Haussmann, F-75360 Paris Cedex 08 (FR)**

(74) Mandataire: **Turlèque, Clotilde et al, THOMSON-CSF
SCPI 173, Bld Haussmann, F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Dispositif de filtrage à faible distorsion de phase et circuit de traitement de signaux
de télévision couleur comportant un tel dispositif

La présente invention concerne les dispositifs de filtrage à faible distorsion de phase de signaux analogiques et en particulier ceux qui sont utilisés dans les circuits de traitement de signaux de télévision couleur réalisant le séparation de la luminance et de la chrominance.

Il est nécessaire de séparer la luminance de la chrominance dans diverses applications. Certaines, telles que le décodage des signaux de couleurs primaires, tolèrent un résidu non négligeable de chrominance.

D'autres, telles que le transcodage d'un système dans un autre, sont beaucoup plus exigeantes, il est alors nécessaire de laisser dans la luminance moins de quelques pour cent de chrominance afin de réduire les défauts résultant, en particulier, des interférences entre ces résidus et la nouvelle chrominance.

De plus, le dispositif de filtrage ne doit introduire qu'un minimum de défauts sur les signaux de luminance, en particulier une distorsion de phase minimale.

Il est connu d'effectuer cette séparation à l'aide d'un filtre en peigne qui met à profit la relation de phase existant entre les signaux de chrominance d'une ligne à l'autre pour annuler ceux-ci par sommation de plusieurs lignes successives de signal vidéofréquence.

Cette méthode présente divers inconvénients: elle ne s'applique qu'aux signaux vidéofréquence couleur de certains systèmes, dans lesquels les signaux de chrominance sont en relation de phase définie d'une ligne sur l'autre comme le PAL ou le NTSC; elle est inapplicable sur le SECAM. De plus, elle suppose une invariance suffisante d'une ligne à l'autre des signaux de luminance et de chrominance, ce qui est obtenu sur les signaux de test, alors fidèlement restitués, mais non en exploitation, où sont observées des dégradations statistiques de la qualité des images.

Une autre solution connue, beaucoup plus générale, applicable au SECAM et à d'autres opérations de traitement consiste dans un filtrage des signaux. Compte tenu que la partie du spectre de luminance dont les fréquences sont plus élevées que celles de la chrominance s'avère quasiment inefficace pour la définition de l'image avec les moyens de restitution connus, un simple filtre passe bas suffit.

Mais la frontière inférieure du spectre de la chrominance étant relativement basse, environ 3,2 MHz par exemple pour les procédés PAL et SECAM 625 lignes, ce filtre doit présenter une frontière très raide, ce qui est difficilement compatible avec une faible distorsion de phase dans la bande passante. Les dispositifs de filtrage connus réalisent un compromis de qualité insuffisante.

L'objet de l'invention est de pallier ces inconvénients.

Selon l'invention, un dispositif de filtrage de signaux analogiques, comportant une ligne à retard d'impédance caractéristique Z ayant une entrée E, une sortie principale $S_o$, et des sorties intermédiaires échelonnées de cette sortie $S_o$ vers l'entrée E, et un dispositif de calcul relié aux sorties de la ligne à retard, est caractérisé en ce que le dispositif de filtrage a son entrée reliée à l'entrée d'un séparateur dont la sortie d'impédance interne égale à Z est reliée à l'entrée de la ligne à retard, cette ligne étant ouverte à son extrémité, en ce que les prises de sortie intermédiaires sont en nombre pair, $S_1$ à $S_{2n}$, les retards introduits entre deux prises successives étant égaux au retard introduit entre la dernière prise de sortie $S_{2n}$ et l'entrée E, et en ce que le dispositif de calcul a des entrées d'impédance interne infinie respectivement connectées à la sortie $S_o$, aux sorties de rangs impairs, $S_1$, $S_3$ ... $S_{2n-1}$, et à l'entrée E, ces entrées étant reliées à des multiplicateurs $A_j$, de coefficients $K_o$ et $K_j = \dfrac{(-1)j + 1}{\pi(2j - 1)}$ pour j variant de 1 à n + 1, les sorties des multiplicateurs étant reliées à un sommateur algébrique ayant une sortie couplée à la sortie du dispositif de filtrage.

L'invention a également pour objet un circuit de traitement de signaux de télévision couleur comportant un tel dispositif de filtrage.

L'invention sera mieux comprise et d'autres caractéristiques apparaîtront à l'aide de la description ci-après et des dessins s'y rapportant sur lesquels:
— la figure 1 est un schéma de principe du dispositif de filtrage selon l'invention;
— la figure 2 est un schéma d'un circuit de traitement de signaux de télévision couleur réalisant la séparation de la luminance et de la chrominance et comportant un dispositif de filtrage selon l'invention.

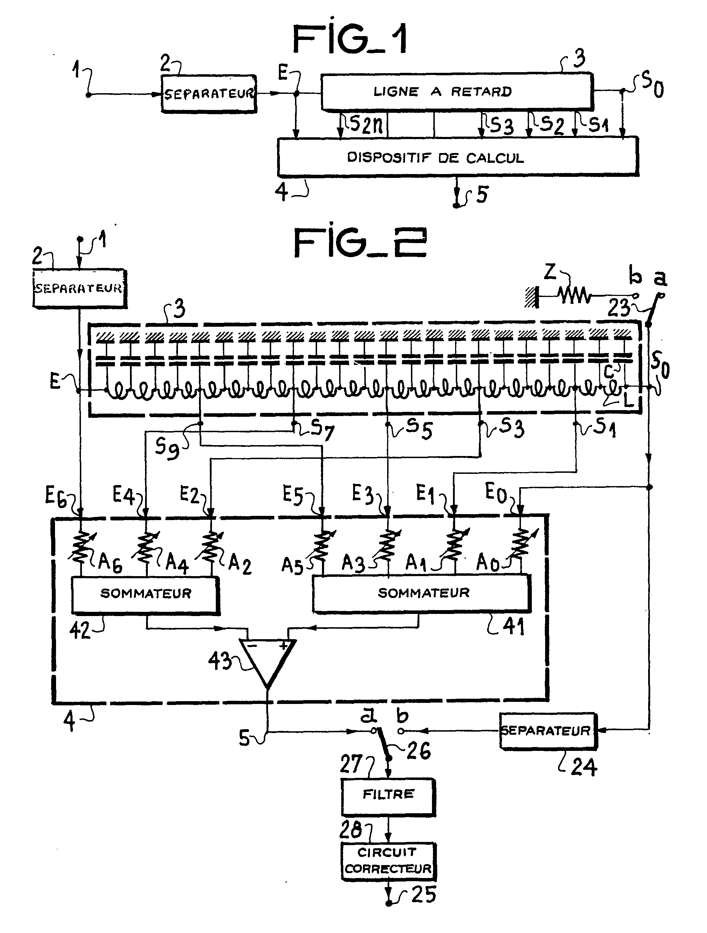

Sur la figure 1, une borne d'entrée 1 destinée à recevoir des signaux analogiques à filtrer est connectée à travers un séparateur 2, à l'entrée E d'une ligne à retard 3, d'impédance caractéristique Z, ayant une sortie principale $S_o$, et 2n sorties intermédiaires dont sont seules représentées les trois premières, $S_1$, $S_2$, $S_3$ et la dernière $S_{2n}$. Un dispositif de calcul 4 comporte 2n + 2 entrées respectivement connectées à l'entrée E, aux sorties $S_o$ et $S_1$ à $S_{2n}$, et une sortie 5 constituant la sortie du dispositif de filtrage.

Les 2n + 2 entrées du dispositif 4 ont une impédance très élevée vis-à-vis de l'impédance Z de la ligne, de sorte qu'elles n'interviennent pas sur le fonctionnement de cette dernière.

C'est-à-dire que, si la dissipation de la ligne est négligeable, tout signal appliqué à l'entrée E de la ligne y retournera avec la même amplitude. Le séparateur 2 présente une impédance interne apériodique égale à Z à l'entrée E, quelle que soit l'impédance interne de la source générant les signaux appliqués à la borne 1, de sorte que les signaux réfléchis retournant en E sont dissipés dans l'impédance interne du séparateur et qu'il n'est accompli qu'un aller et retour sur la ligne.

Si $\varphi$ représente la différence de phase d'un signal entre la première sortie intermédiaire $S_1$ et la sortie $S_o$, où la phase est prise comme référence, toutes les autres sorties intermédiaires sont connectées sur la ligne de manière que cette même différence de phase $\varphi$ existe entre deux sorties consécutives ou entre la dernière sortie intermédiaire $S_{2n}$ et l'entrée E.

Il en résulte qu'à une sortie intermédiaire quelconque $S_m$, (m choisi quelconque entre 1 et 2n), un signal d'amplitude U dont la phase en $S_o$ est prise pour origine sera en $S_m$ un signal $U_m$ résultant des signaux aller et retour, et donné par

$$U_m = U(e^{jm\varphi} + e^{-jm\varphi}) = 2U \cos m\varphi.$$

De même à l'entrée E on aura

$$U_E = 2U \cos (2n+1) \varphi.$$

Le dispositif de calcul 4 comporte $2n+2$ circuits multiplicateurs à savoir un circuit de coefficient $K_o$ appliqué au signal $U_o$ délivré par la sortie $S_o$, 2n circuits de coefficient $K_m$ c'est-à-dire $K_1$, $K_2$ ... $K_{2n}$ respectivement appliqués aux signaux $U_1$, $U_2$ ... $U_{2n}$ des sorties correspondantes $S_1$, $S_2$ ... $S_{2n}$ et un circuit de coefficient $K_{2n+1}$ appliqué au signal $U_{2n+1}$ présent à l'entrée de E. Enfin il comporte un sommateur de l'ensemble des signaux de sortie des circuits multiplicateurs.

Si les coefficients $K_o$, $K_m$ et $K_{2n+1}$ ont les valeurs suivantes:

$$K_o = k, \quad K_m = \frac{\sin mk\pi}{m\pi}, \quad K_{2n+1} = \frac{\sin (2n+1) k\pi}{(2n+1) \pi},$$

avec $0 < k < 1$,
le sommateur du dispositif 4 délivrera un signal résultant $U_R$ tel que

$$U_R = Uk + 2U \frac{\sin k\pi}{\pi} \cos \varphi + 2U \frac{\sin 2k\pi}{2\pi} \cos 2\varphi ...$$

$$... + 2U \frac{\sin(2n+1)k\pi}{(2n+1)\pi} \cos (2n+1) \varphi$$

soit $$U_R = U \left\{ k + \frac{2}{\pi} (\sin k\pi \cos \varphi + \frac{\sin 2k\pi}{2} .... \right.$$

$$\left. ...\cos 2\varphi + \frac{\sin (2n+1)k\pi}{(2n+1)} \cos (2n+1) \varphi) \right\} \quad (1)$$

Si $n \to \infty$, cette équation exprime la décomposition en série de Fourier d'un signal périodique constitué d'impulsions rectangulaires d'amplitude U et de largeur $2k\pi$. C'est-à-dire que $U_R = U$ sera obtenu en sortie du dispositif de filtrage pour tout signal sinusoïdal d'amplitude U et de fréquence F inférieure à celle correspondant à une différence de phase $\varphi = k\pi$, et $U_R = O$ sera obtenu pour les signaux de fréquence correspondant à $k\pi < \varphi < (2-k)\pi$, $U_R$ étant de nouveau égal à U si $(2-k)\pi < \varphi < (2+k)\pi$ et ainsi de suite.

Ainsi un filtre passe bas de frontière F sera réalisé si la fréquence maximale à éliminer introduit un déphasage $\varphi$ inférieur à $(2-k)\pi$.

Mais il peut être transformé en filtre passe haut en remplaçant $K_o$ par un coefficient de polarité inverse $K'_o = -k$, lequel passe haut devenant un passe bande si la fréquence des signaux appliqués au dispositif est telle que la valeur de $\varphi$ dépasse $(2+k)\pi$ tout en étant inférieure à $(4-k)\pi$.

La figure suivante montre un exemple d'application en filtre passe bas dans le cas particulier où $k = \frac{1}{2}$, ce qui permet d'éliminer les harmoniques paires

de la série de Fourier et les sorties intermédiaires correspondantes de la ligne à retard 3.

Sur la figure 2, où les mêmes repères désignent les mêmes organes que sur la figure 1, la ligne à retard 3 est représentée sous forme d'un filtre passe bas à 22 cellules identiques en $\pi$ comportant chacune une self inductance L en série et deux condensateurs C en dérivation. Les sorties intermédiaires $S_m$ sont échelonnées toutes les deux cellules, mais seules les sorties intermédiaires impaires $S_1$, $S_3$, $S_5$, $S_7$ et $S_9$ sont utilisées et représentées, elles se trouvent donc espacées par 4 cellules, et sont respectivement connectées aux entrées $E_1$ à $E_5$ du dispositif 4, les entrées $E_o$ et $E_6$ étant respectivement reliées à la sortie $S_o$ et à l'entrée E de la ligne 3.

Le dispositif 4 comporte: un premier sommateur 41 ayant quatre entrées reliées respectivement aux entrées $E_o$, $E_1$, $E_3$ et $E_5$ du dispositif à travers les atténuateurs correspondants $A_o$, $A_1$, $A_3$ et $A_5$, un deuxième sommateur 42 ayant trois entrées respectivement connectées aux entrées $E_2$, $E_4$ et $E_6$ à travers les atténuateurs correspondants $A_2$, $A_4$ et $A_6$, et un amplificateur opérationnel 43 dont les entrées $(+)$ et $(-)$ sont respectivement connectées aux sorties des sommateurs 41 et 42, et dont la sortie 5 est couplée à la sortie 25 du circuit de traitement à travers le contact a d'un inverseur 26, un filtre complémentaire 27 et un circuit correcteur de phase et d'amplitude 28 montés en série. Le contact b de l'inverseur 26, relie l'entrée du filtre 27 à travers un séparateur 24, la sortie $S_o$ qui est chargée sur une impédance Z à travers le contact b d'un inverseur 23 et ouverte à travers le contact a. Le séparateur 24 présente une impédance d'entrée très élevée afin de ne pas perturber la réflexion totale des signaux parvenant à la sortie $S_o$ du filtre 3.

Le fonctionnement sera d'abord décrit en supposant fermés les circuits a des inverseurs 23 et 26.

Puisque $k = \frac{1}{2}$, l'équation (1), limitée aux termes présents aux entrées $E_o$ et $E_1$ à $E_6$ du dispositif 4, s'écrit alors

$$U_R = \frac{U}{2} + \frac{2}{\pi} (\cos\varphi - \frac{1}{3} \cos3\varphi + \frac{1}{5} \cos5\varphi .....$$

$$- \frac{1}{11} \cos 11\varphi) \quad (2)$$

et les coefficients de pondération deviennent respectivement

$$K_o = \frac{1}{2}, \quad K_1 = \frac{1}{\pi}, \quad K_2 = - \frac{1}{3\pi}, \quad K_3 = \frac{1}{5\pi} ... K_6 = - \frac{1}{11\pi}$$

qui représentent les coefficients d'atténuation à donner en valeur absolue, aux atténuateurs correspondants, $A_o$ et $A_1$ à $A_6$, la valeur algébrique étant donnée par leur répartition devant les 2 entrées de l'amplificateur 43.

Pour $\varphi = \frac{\pi}{2}$ où l'équation (2) se résume à $U_R = \frac{U}{2}$, quel que soit le nombre de termes considérés, le

dispositif de filtrage présente donc une perte d'insertion de 6dB. A cette valeur de phase particulière il est associé une fréquence de coupure F = 3,4 MHz du dispositif de filtrage, dans l'exemple particulier décrit, destiné à effectuer la séparation de la luminance et de la chrominance d'un signal de télévision couleur.

Ce déphasage de $\dfrac{\pi}{2}$ étant donné par deux cellules en série, chacune d'elles présente une déphasage de $\dfrac{\pi}{4}$ à la fréquence F d'où la fréquence de coupure du filtre seul $F_c$ donnée par $\dfrac{\pi}{4} = 2\,\mathrm{arc\,sin}\,\dfrac{F}{F_c}$ d'où $F_c$ = 8,88 MHz ce qui permet de déterminer entièrement les éléments de base du filtre, L et C en fonction de Z.

A un déphasage de $\dfrac{\pi}{8}$ correspond une fréquence $F_M$ donnée par $2\,\mathrm{arc\,sin}\,\dfrac{F_M}{F_c} = \dfrac{\pi}{8}$ soit $F_M$ = 1,733 MHz.

Ainsi, il a été vu que le dispositif présente une bonne linéarité de phase en fonction de la fréquence puisqu'à un déphasage moitié correspond une fréquence qui n'est qu'à 2% environ de la fréquence centrale de la bande passante (1,7 MHz).

Il est à noter que cette distorsion de phase n'a d'autre inconvénient que de nécessiter l'emploi comme il vient d'en être fait, d'une relation non linéaire entre $\varphi$ et F pour faire coïncider la fréquence de coupure souhaitée avec un déphasage égal à $\dfrac{\pi}{2}$ de chaque cellule élémentaire.

Le nombre limité de cellules du filtre 3, résulte d'un compromis entre une approximation de la formule théorique (1) d'autant meilleure que ce nombre est grand, et les effets de la dissipation parasite dans le filtre, qui augmentent avec ce nombre. Ainsi, il existe des ondulations dans les bandes passante et atténuée du dispositif ainsi qu'une pente de la caractéristique au voisinage de la fréquence de coupure.

Ces effets, connus sous le nom de phénomènes de Gibbs, ou effet de troncature, sont atténués en donnant, expérimentalement, aux derniers atténuateurs, $A_4$ à $A_6$ des valeurs d'atténuation un peu plus élevées que celles qui résulteraient des termes correspondants de la série de Fourier.

De plus le filtrage est complété par le filtre complémentaire 27 à trappes de réjection de chrominance, suivi du correcteur de phase et d'amplitude 28 qui font partie tous deux des dispositifs classiques de séparation luminance/chrominance dans les applications courantes, où ils resteront seuls utilisés en positionnant les inverseurs 23 et 26 sur leur circuit b, le filtre 3 étant alors normalement adapté et n'étant plus qu'un filtre passe bas des composantes parasites hors bande qui peuvent être mélangées au signal utile.

**Revendications**

1. Dispositif de filtrage de signaux analogiques, comportant une ligne à retard (3) d'impédance caractéristique Z ayant une entrée E, une sortie principale $S_o$, et des sorties intermédiaires échelonnées de cette sortie $S_o$ vers l'entrée E, et un dispositif de calcul (4) relié aux sorties de la ligne à retard, caractérisé en ce que le dispositif de filtrage a son entrée reliée à l'entrée d'un séparateur (2) dont la sortie d'impédance interne égale à Z est reliée à l'entrée (E) de la ligne à retard, cette ligne étant ouverte à son extrémité, en ce que les prises de sortie intermédiaires sont en nombre pair, $S_1$ à $S_{2n}$, les retards introduits entre deux prises successives étant égaux au retard introduit entre la dernière prise de sortie $S_{2n}$ et l'entrée E, et en ce que le dispositif de calcul (4) a des entrées d'impédance interne infinie respectivement connectées à la sortie $S_o$, aux sorties de rangs impairs, $S_1$, $S_3$ ... $S_{2n-1}$, et à l'entrée E, ces entrées étant reliées à des multiplicateurs $A_j$ de coefficients $K_o$ et $K_j = \dfrac{(-1)^{j+1}}{\pi(2j-1)}$ pour j variant de 1 à n + 1, les sorties des multiplicateurs étant reliées à un sommateur algébrique (41, 42, 43) ayant une sortie (5) couplée à la sortie du dispositif de filtrage (25).

2. Dispositif de filtrage selon la revendication 1, caractérisé en ce que $K_o$ est choisi égal à $-1$, le dispositif étant un filtre passe bande pour toutes les fréquences induisant un déphasage $\varphi$ entre les sorties $S_o$ et $S_1$ compris entre $\dfrac{\pi}{2}$ et $\pi$.

3. Dispositif de filtrage selon la revendication 1, caractérisé en ce que $k_o$ = 1/2, le dispositif étant un filtre passe bas pour toutes les fréquences induisant un déphasage $\varphi$ entre les sorties $S_o$ et $S_1$ compris entre 0 et $\dfrac{\pi}{2}$.

4. Dispositif de filtrage selon la revendication 3, caractérisé en ce que la ligne à retard (3) est un filtre passe bas à K constant comportant 2n + 1 cellules en $\pi$ identiques, à savoir deux entre les sorties S et $S_1$ et quatre entre deux sorties intermédiaires impaires consécutives ainsi qu'entre l'entrée E et la sortie intermédiaire adjacente.

5. Circuit de traitement de signaux de télévision en couleur destiné à séparer les signaux de luminance des signaux de chrominance, caractérisé en ce qu'il comprend un dispositif de filtrage selon l'une des revendications 3 et 4.

**Patentansprüche**

1. Vorrichtung zur Filterung von Analogsignalen, mit einer Verzögerungsleitung (3) der charakteristichen Impedanz Z und mit einem Eingang E, einem Hauptausgang $S_o$ und Zwischenausgängen, die von diesem Ausgang $S_o$ zum Eingang E hin gestaffelt sind, und mit einer Rechenvorrichtung (4), die mit den Ausgängen der Verzögerungsleitung verbunden ist, dadurch gekennzeichnet, dass der Eingang der Filtervorrichtung mit dem Eingang eines Separators (2) verbunden ist, dessen den Innenwiderstand Z aufweisender Ausgang mit dem Eingang E der Verzögerungsleitung verbunden ist, wobei diese Leitung an ihrem Ende offen ist, dass die Anzahl der Zwischenausgangsanschlüsse $S_1$ bis $S_{2n}$ geradzahlig ist, wobei die zwischen zwei aufeinanderfolgenden Anschlüssen eingefügten Verzögerungen gleich der Verzögerung sind, die zwischen dem letzten Ausgangsanschluss $S_{2n}$ und dem Eingang E auftritt, und dass die Rechenvorrichtung (4) Eingänge mit unendlich grosser Impedanz aufweist, die jeweils angeschlossen sind an den Ausgang $S_o$ bzw. an die Ausgänge mit ungeradzahliger Ordnungszahl $S_1, S_3 \ldots S_{2n-1}$ bzw. mit dem Eingang E, wobei diese Eingänge mit Multiplikatoren $A_j$ verbunden sind, welche mit den Koeffizienten $K_o$ und $K_j = \dfrac{(-1)^{j+1}}{\pi(2j-1)}$ multiplizieren, für j von 1 bis $n+1$ variierend, und wobei die Ausgänge der Multiplikatoren mit einem algebraischen Summierer (41, 42, 43) verbunden sind, dessen Ausgang (5) an den Ausgang der Filtervorrichtung (25) angekoppelt ist.

2. Filtervorrichtung nach Anspruch 1, dadurch gekennzeichnet, dass $K_o$ gleich $-1$ gewählt ist, wobei die Vorrichtung ein Bandpassfilter für alle Frequenzen ist, die eine Phasenverschiebung $\phi$ zwischen den Ausgängen $S_o$ und $S_1$ erzeugen, die zwischen $\dfrac{\pi}{2}$ und $\pi$ liegt.

3. Filtervorrichtung nach Anspruch 1, dadurch gekennzeichnet, dass $k_o = 1/2$, wobei die Vorrichtung ein Tiefpassfilter für alle Frequenzen ist, die eine Phasenverschiebung $\phi$ zwischen den Ausgängen $S_o$ und $S_1$ erzeugen, welche zwischen 0 und $\dfrac{\pi}{2}$ liegt.

4. Filtervorrichtung nach Anspruch 3, dadurch gekennzeichnet, dass die Verzögerungsleitung (3) ein Tiefpassfilter bei konstantem K ist, das $2n+1$ $\pi$-förmige gleiche Stufen enthält, nämlich zwei zwischen den Ausgängen S und $S_1$ und vier zwischen zwei ungeradzahligen aufeinanderfolgenden Zwischenausgängen sowie zwischen dem Eingang E und dem angrenzenden Zwischenausgang.

5. Verarbeitungsschaltung für Farbfernsehsignale, die dazu bestimmt ist, die Luminanzsignale und die Chrominanzsignale zu trennen, dadurch gekennzeichnet, dass sie eine Filtervorrichtung nach einem der Ansprüche 3 und 4 enthält.

## Claims

1. Analog signal filtering device comprising a delay line (3) having a characteristic impedance Z and an input E, a main output $S_o$ and intermediate outputs staggered from this output $S_o$ towards the input E, and a computing device (4) connected to the outputs of the delay line, characterized in that the filtering device has its input connected to the input of a separator (2) the output of which has an internal impedance of Z and is connected to the input E of the delay line, this line being open on its end, in that the number of intermediate output taps $S_1$ to $S_{2n}$ is an even number, the delays introduced between two successive taps being equal to the delay introduced between the last output tap $S_{2n}$ and the input E, and in that the computing device (4) has inputs having an infinite internal impedance and which are connected to the output $S_o$, to the outputs of odd orders $S_1, S_3 \ldots S_{2n-1}$ and to the input E, respectively, these inputs being connected to multipliers $A_j$ multiplying by coefficients $K_o$ and $K_j = \dfrac{(-1)^{j+1}}{\pi(2j-1)}$, for j varying from 1 to $n+1$, the outputs of the multipliers being connected to an algebraic summer (41, 42, 43) having an output (5) coupled to the output of the filtering device (25).

2. Filtering device according to claim 1, characterized in that $K_o$ is selected equal to $-1$, the device being a band pass filter for any frequency introducing a phase shift $\phi$ between the outputs $S_o$ and $S_1$ comprised between $\dfrac{\pi}{2}$ and $\pi$.

3. Filtering device according to claim 1, characterized in that $k_o = 1/2$, the device being a low pass filter for any frequency introducing a phase shift $\phi$ between the outputs $S_o$ and $S_1$ comprised between 0 and $\dfrac{\pi}{2}$.

4. Filtering device according to claim 3, characterized in that the delay line (3) is a low pass filter having a constant K and comprising $2n+1$ identical $\pi$-stages, i.e. two between the outputs S and $S_1$ and four between two successive odd intermediate outputs as well as between the input E and the adjacent intermediate output.

5. Circuit for processing color television signals for separating luminance and chrominance signals, characterized in that it comprises a filtering device according to any of claims 3 and 4.

# FIG_1

# FIG_2